Europäisches Patentamt

European Patent Office

Office européen des brevets

(19)

(11) Publication number: **0 295 948**
**A2**

(12) # EUROPEAN PATENT APPLICATION

(21) Application number: 88305565.9

(22) Date of filing: 17.06.88

(51) Int. Cl.⁴: **H 01 L 23/50**

(30) Priority: 17.06.87 US 63344

(43) Date of publication of application:
21.12.88 Bulletin 88/51

(84) Designated Contracting States: DE FR GB IT SE

(71) Applicant: TANDEM COMPUTERS INCORPORATED
19333 Vallco Parkway
Cupertino California 95014 (US)

(72) Inventor: Hoss, Paul-André
1199 Bernardo Avenue
Sunnyvale California 94087 (US)

(74) Representative: Ayers, Martyn Lewis Stanley et al
J.A. KEMP & CO. 14 South Square Gray's Inn
London, WC1R 5EU (GB)

(54) Improved VLSI package having multiple power planes.

(57) The present invention provides a pin grid or other chip package which allows for the matching of two different semi-conductor chips when the chips have different locations for their power pads. The package of the present invention achieves this end by realigning the terminals of the package, such as the pins of a pin grid package, with the use of vias which couple the pins to power pads and power planes of the package. The package of the present invention has a plurality of spaced, generally parallel power planes embedded in a package body. These power planes are connected to the power pads by inner vias. The pins of the package are coupled by outer vias to certain power planes in a manner such that the arrangement of the pins for a first chip are the same as that for a second chip.

FIG. 4

EP 0 295 948 A2

**Description**

## IMPROVED VLSI PACKAGE HAVING MULTIPLE POWER PLANES

This invention relates to improvements in packages for semi-conductor chips and, more particularly, to an improved VLSI package of the type having multiple power planes embedded therein and coupled to a plurality of terminal pins.

Background of the Invention:

A circuit board may have one or more pin grid or other chip packages attached (by solder or insertion into a connector) to the circuit board to integrate the chips carried by such packages with the circuitry on the rest of the circuit board itself. A pin grid package has a number of terminal pins which are received in the "footprint" design provided for the package in the printed circuit board or other substrate to accept the package.

It often becomes necessary or desirable, for cost reasons or otherwise, to substitute one chip, such as one made by a first manufacturer, with a second chip, such as one made by a second manufacturer. Sometimes it is necessary to fix the "footprint" early in a design, before all chip sources, current and future, can be identified. Consider the economic advantage of carrying separate boards or substrates for each "footprint" as well as duplicate packaged parts which only fit one kind of board, or even having to replace or rewire boards because one of the chips is no longer available. The main intent is that the conversion of the chip "footprint" to the package "footprint" is more preferably made entirely within the package.

Chips are different in the sense that they have different power/ground path arrangements on the chip. In certain chips, such as bipolar gate array chips, where the logic (input and/or output signals) are chip mask programmable, their locations can be easily assigned on the chip to match their paths in the package. The power/ground paths are often not chip programmable, particularly with chips that require multiple pads on the chip to carry the electrical load with low resistance as well as low inductive paths. They use up wide paths within the package to meet these electrical requirements. In a few cases, the chip design fortuitiously allows the package design change to be achieved by movement of these paths within the package without an unreasonable increase in the path resistance or inductance.

Because of these drawbacks, it is desirable to avoid having to replace "footprint" connectors and, instead, to make changes elsewhere which are not so expensive and time-consuming. The present invention provides a solution to the problem by providing an improved pin grid or other package for a replacement chip so that the package can be used with an existing "footprint" connector without replacing the latter or without having to rewire the circuit board on which the connector is mounted.

Summary of the Invention:

The present invention provides a pin grid or other chip package which allows for the matching of two different semi-conductor chips when the chips have different locations for their power pads. The present invention achieves this end by realigning the terminals of the package, such as the pins of a pin grid package, with the use of vias which couple the pins to power pads and power planes of the package. In this way, chips from different vendors or with different power pad assignments can be made to look the same at the circuit board level so that the package itself does the matching rather than having to rewire the circuit board.

Most high frequency packages and substrates now contain power/ground planes to improve the electrical properties, such as lowering the impedance and reducing the cross-talk. The present invention builds on the concept of using planes within a package.

The present invention has a plurality of spaced, generally parallel power planes embedded in the package body itself. These power planes are connected to the power pads by inner vias. Moreover, the pins of the package are coupled by outer vias to certain power planes in a manner such that the arrangement of the pins for a first chip are the same as that for a second chip notwithstanding the fact that the power pads for the two chips are arranged differently from each other.

This invention allows for package mask programmability in the design of the package so that almost any combination of power/ground pad combinations on the chip can be set to a predetermined footprint at the board. In other words, minor changes to the original package are made instead of major changes to the chip itself. The term "programmable" as used here refers to change by simple modifications of the metallization paths and intermetal paths or vias.

The primary object of the present invention is to provide an improved pin grid or other chip package for a semi-conductor chip wherein the package is made such that the plurality of power planes in the package are coupled to external pins and to the power pads of a second chip and the arrangement of the external pins of the package is the same as that for a first chip even though the power pads of the two chips different from each other.

Other objects of this invention will become apparent as the following specification progresses, reference being had to the accompanying drawings for an illustration of the invention.

In the Drawings:

Fig. 1 is a perspective view of a prior art pin grid package for a semi-conductor chip bonded to a substrate in a known manner, the chip being surrounded by a plurality of pins extending outwardly from the package in one direction;

Fig. 2 is a top plan view of the package of Fig. I, showing the chip coupled by bonding wires to power pads in a power layer of the package;

Fig. 3 is a fragmentary, perspective view of the package of Fig. 1, showing the way in which it is coupled to a complementary "footprint" connector member mounted on a circuit board, such as a printed circuit board;

Fig. 3A is a fragmentary, top plan view of the semi-conductor chip of the package of Fig. 1, showing the power pads in more detail and illustrating the vias for the power pads at the outer ends thereof;

Fig. 4 is a schematic view of a fragment of the package of Fig. I, showing the chip in place and showing a pair of pins coupled by outer vias to specific ones of the power pads of Fig. 3 for a particular chip;

Fig. 5 is a fragmentary, enlarged view of a power layer, showing the way in which a via is passed through the layer without making electrical contact therewith;

Fig. 6 is a view similar to Fig. 3 but showing the power pads for a package having a semi-conductor chip different from the chip shown in Fig. 3, and further illustrating the outer vias of Fig. 3 separate from the power pads with the addition of inner vias separate from the outer vias with the inner vias being coupled to respective power pads at the outer ends thereof;

Fig. 7 is a view similar to Fig. 4 but showing the inner and outer vias for a pair of mounting pins and further showing the way in which the pins are connected so that the package of Fig. 7 can be used with the "footprint" connector and the package of Fig. 4; and

Fig. 8 is a fragmentary plan view of several stacked planes of the package of Figs. 6 and 7, showing how the inner vias couple the power pads of the chip to power planes not coplanar with the power pads.

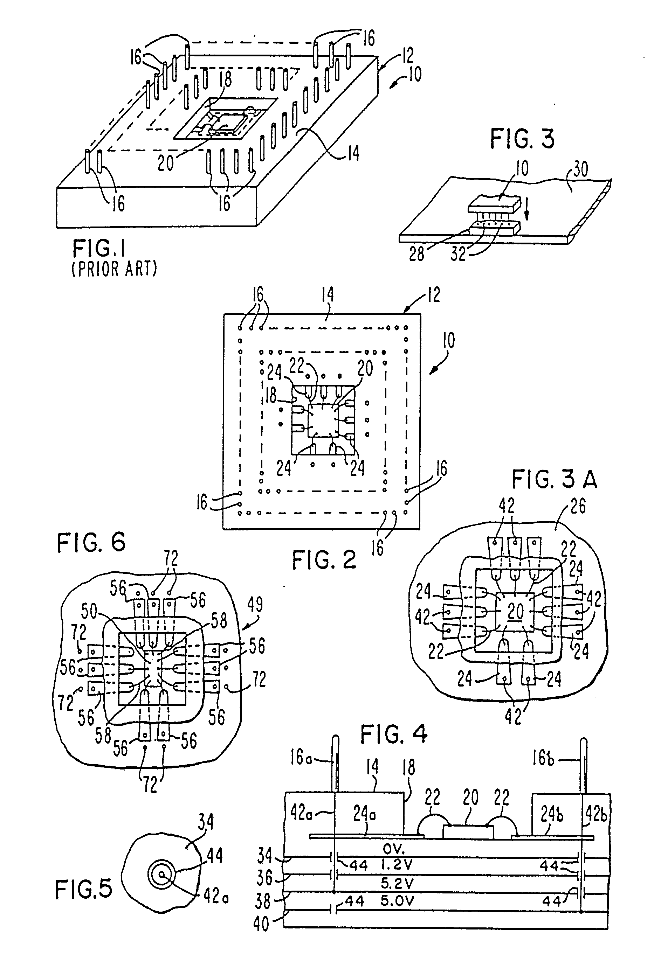

A prior art pin grid package for mounting a semi-conductor chip is shown in Figs. 1 and 2 and is denoted by the numeral 10. Package 10 includes a package body 12 having a face 14 provided with a plurality of vertical pins 16 located in a generally symmetrical array; however, the pins could be in any arrangement, if desired.

The pins are all of the same length as they project outwardly from face 14 of package body 12. The pins surround a recess 18 in which a pad (not shown) for mounting a semi-conductor chip 20 is located. The bonding of the chip 20 to the pad can be achieved in a conventional manner, and lead wires 22 shown in more detail in Figs. 2 and 3, bond certain terminals of chip 20 to the inner ends of power pads 24 mounted on a power layer 26 forming a part of body 12 of package 10. The power pads 24 are arranged in a particular manner for a particular chip 20; thus, the package 10 generally cannot be used with any other chip unless the package is modified and improved in the manner hereinafter described with respect to the present invention.

Package 10 has other pads or terminals similar to power pads 24, such other terminals or pads being adapted for use as conductors for signals directed toward and away from chip 20. Typically, the inner pins 16 surrounding recess 18 are coupled to the power pads 24; whereas, the outer rows of pin are used as signal terminals.

A completed package 10 is, for instance, used with a "footprint" device, such as a female connector member 28, mounted on a circuit board 30, such as a printed circuit board, whereby the pins 16 of package 10 enter respective holes 32 in connector member 28 and thereby are coupled to the circuitry on circuit board 30 in a proper manner to achieve a particular end, such as to provide data signals directed toward and away from chip 20.

Package 10 has a number of power planes therein to which certain pins 16 are connected. Four such power planes are shown in Fig. 4 in connection with two particular pins 16a and 16b. The pins as shown in Fig. 4 project outwardly from face 14 at a location adjacent to recess 18 in which chip 20 is located, certain terminals of the chip being coupled by a pair of bonding wires 22 to a pair of the pads 24 which typically supply voltages at different levels to chip 20 by way of wires 22. For instance, layer 24a can represent the voltage level of 5.2 volts DC and layer 24b could represent a voltage level of 0 volts.

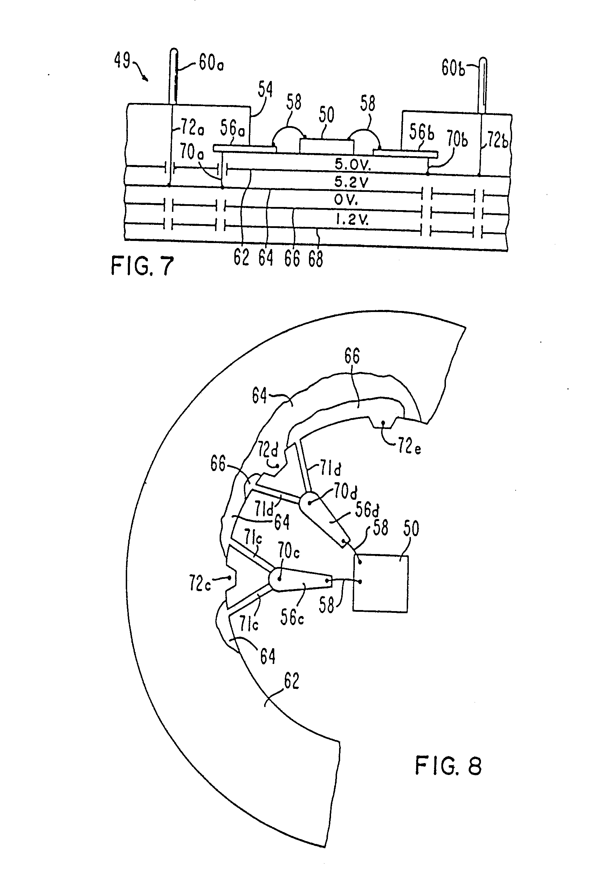

Package 10 further has power planes 34, 36, 38 and 40 (Fig. 4), all such planes being spaced apart and generally parallel with each other and typically have circular shapes as shown in Fig. 8 although this is not necessary. Each of the power pads 24 is coupled by an outer via 42 to a respective pin 16a and to a respective power plane in the group of power planes 34, 36, 38 and 40. For instance, if power pin 16a is to be coupled to the 5.2 volt connector terminal of "footprint" connector 28 (Fig. 3), and if power pad 24a is to represent the 5.2 volt terminal for this voltage, a via 42a will be connected to pin 16a, and to pad 24a as well as to plane 38. Plane 38 will then be at a voltage level of 5.2 volts and can be connected to other terminal 16 (not shown in Fig. 4) which are required to be at the 5.2 voltage level.

Via 42a will pass through planes 34 and 36 without contacting such planes. To this end, via 42a passes through what in effect are tubular insulators 44 in the manner shown in Figs. 4 and 5. The via will terminate before it reaches plane 40; thus, plane 38 will be representing the 5.2 volt via while the other planes 34, 36 and 40 will represent other voltages, such as 0 volts, 1.2 volts and 5.0 volts, respectively. There will be other vias 42 for connecting other pins 16 to respective power planes and power pads 24.

Similarly, assuming that pin 16b represents the 5.0 volt pin when coupled with "footprint" connector member 28 (Fig. 3), pin 16b will be connected by a via 42b which will also be connected to power pad 24b and via 42b will pass through planes 34, 36 and 38 without making electrical contact with these planes. This is achieved by using what in effect are tubular insulators 44 of the type shown in Fig. 5. Via 42b will be connected as shown to plane 40 which will be the 5.0 volt plane.

One of the major advantages of having separate planes for power is that, similarly to that which is often done with printed circuit boards, the voltages above and at ground level can be tapped at any points on the planes. Thus, all of the foregoing description is conventional.

In the case of pin grid or other chip packages, the concept of separate power planes allows for matching of different semi-conductor chips with different locations for power pads by realigning the pins of the package. In this way, the chips from different manufacturers or with different power pad assignments can be made to look the same at the circuit board level so that matching of the power pads with the "footprint" connector member 28 on the circuit board is achieved by redesigning the package rather than having to redesign the circuit board. The package of the present invention is denoted by the numeral 49.

This matching can be achieved in package 49 of the present invention by using a second set of vias with a first set of vias of the type described above as outer vias 42. The second set are hereinafter referred to as the inner vias, there being an inner via for each outer via, respectively. Matching is achieved when a different chip 50 (Fig. 7) is coupled to package 49 in a recess 54 of the package, there being a number of power pads 56 which are bonded by wires 58 to specific terminals on chip 50. The two power pads shown in Fig. 7 are denoted by numerals 56a and 56b to simplify the description of the present invention as described hereinafter. It is to be understood that the package 49 will have the power pads 56 as shown in Fig. 6.

Package 49 has a plurality of pins 60 protecting outwardly from one face of the package. Only two of pins 60 are shown in Fig. 7 and they are denoted by the numerals 60a and 60b to distinguish them from each other. Package 49 further has power planes 62, 64, 66 and 68 which are generally parallel with each other and are typically at different voltage levels with respect to each other. For instance,level 62 is at 5.0 volts, level 64 is at 5.2 volts,level 66 is a 0 volts and level 68 at 1.2 volts. If it is desired to have the power pad assignments for power pads 56 made to look the same at the circuit board level as the power pad assignments of the package 10 (Fig. 4), then pins 60a and 60b must have the same voltage levels associated therewith, pin 60a being in the same location as pin 16a (Fig. 4) and pin 60b being in the same location as pin 16b (Fig. 4).

To connect pin 60a to the 5.2 power plane, namely plane 64 in Fig. 7, an inner via 70 is used with the corresponding power pad 56a so that the inner via 70a passes through plane 62 and terminates at plane 64 as shown in Fig. 7. The corresponding outer via 72a is coupled to pin 60a and passes through plane 62 and terminates at plane 64. Thus, power pad 56a is associated with pin 60a which is, in turn, associated with the 5.2 volt level.

Similarly, an inner via 70b couples power pad 56b with plane 62 which in turn is coupled by an outer via 72b with pin 60b. In this way, the pins 60a and 60b are matched with pins 16a and 16b of package 10 so that the packages 49 and 10 are made to look the same at the "footprint" connector 28 (Fig. 3) of circuit board 30.

Fig. 8 shows the way in which a pair of power pads 56c and 56d are coupled to power planes which are not coplanar with the power pads. For instance, power planes 62, 64 and 66 are shown in Fig. 8 and these planes are shown as being vertically stacked upon each other and spaced apart.

Power pad 56c has an inner via 70c adjacent to an outer via 72c coupled rigidly to power plane 62. If it is desired that power pad 56c, which is coplanar with power plane 62, to be coupled to power plane 64, inner via 70c will not be coupled with the adjacent outer via 72c but will be coupled to power plane 64 by means of links 71c. These links 71c will be coplanar with plane 64 and will be coupled rigidly to inner via 70c which will span a distance between the inner ends of links 71c and power pad 56c.

Another example is shown in Fig. 8 wherein power pad 56d is coplanar with plane 64 having outer via 72d and it is desired to couple the inner via 70d with a plane 66 below plane 64, plane 66 having an outer via 72e. To this end, the inner via 70d will be coupled to the inner ends of links 71d which are coplanar with power planes 66 and is coupled thereto by the inner ends of links 71d coupled with the inner via 70d. Thus, inner via 70d is coupled to outer via 72e.

In the foregoing manner, other power pads 56 can be coplanar with each other and out of coplanar relationship with the power planes 62, 64, 66 and 68 and still the inner vias can be used to couple the power pads to respective power planes with the inner vias and links 71.

## Claims

1. A pin grid package for attachment to a circuit comprising: a package body having a location for receiving a semi-conductor chip and allowing the chip to be bonded to the body; a bonding layer on said body and surrounding said location, there being a plurality of power pads coupled to the bonding layer and extending outwardly therefrom; means defining a plurality of power planes in said body; a plurality of inner vias, there being an inner via for each power pad, respectively, each inner via coupling the respective power pad to a respective power plane; a plurality of pins projecting outwardly from the body, said pins adapted to be coupled to the connector of said circuit; and a plurality of outer vias in said body, there being an outer via for each inner via, respectively, each outer via coupling a respective pin with a respective power plane, whereby the pins are coupled to certain power pads by respective inner vias and respective power planes and the pins can be in the same positions with reference to the connector of said circuit as the pins of a package having no inner vias but having outer vias coupled directly to power pads arranged differently from the power pads of said bonding layer.

2. A package as set forth in claim 1, wherein said outer vias are spaced outwardly from the outer ends of respective power pads.

3. A package as set forth in claim 1, wherein the inner and outer vias pass through and are out of electrical contact with certain of the planes.

4. A package as set forth in claim I, wherein the inner and outer vias are parallel with each other.

5. A package as set forth in claim 1, wherein the pins are coextensive with corresponding outer vias.

6. A package as set forth in claim 1, wherein said planes are stacked in said body.

7. A package as set forth in claim 1, wherein said planes are parallel with each other.

8. A package as set forth in claim 7, wherein the vias are perpendicular to said planes.

FIG.1
(PRIOR ART)

FIG. 2

FIG. 3

FIG. 3 A

FIG. 4

FIG. 5

FIG. 6

0295948

FIG. 7

FIG. 8